Europäisches Patentamt

European Patent Office

Office européen des brevets

(11) Veröffentlichungsnummer: **0 167 111**
**B1**

(12) **EUROPÄISCHE PATENTSCHRIFT**

(45) Veröffentlichungstag der Patentschrift: **16.01.91**

(51) Int. Cl.⁵: **G 03 F 7/004**

(21) Anmeldenummer: **85107958.2**

(22) Anmeldetag: **27.06.85**

(54) Verfahren zur Herstellung eines Resistmusters.

(30) Priorität: **30.06.84 DE 3424187**

(43) Veröffentlichungstag der Anmeldung:
**08.01.86 Patentblatt 86/02**

(45) Bekanntmachung des Hinweises auf die
Patenterteilung:
**16.01.91 Patentblatt 91/03**

(84) Benannte Vertragsstaaten:
**CH DE FR GB IT LI**

(56) Entgegenhaltungen:
**DE-A-2 518 274**
**DE-B-1 152 534**
**US-A-4 348 473**
**IBM TECHNICAL DISCLOSURE BULLETIN, Band
24, Nr. 10, März 1982, Seiten 5095-5096, New
York, US; G. CZORNYJ et al.: "Dry development
of high resolution, high sensitivity electronbeam and/or x-ray monomolecular resist
materials"**

(73) Patentinhaber: **BASF Aktiengesellschaft
Carl-Bosch-Strasse 38
D-6700 Ludwigshafen (DE)**

(72) Erfinder: **Petermann, Juergen, Prof. Dr.
Westpreussenweg 12
D-2150 Buxtehude (DE)**
Erfinder: **Fuchs, Harald, Dr.
In den Maulgärten 17
D-6718 Grünstadt (DE)**

(56) References cited:
**J. KOSAR: "Light-senstive systems: chemistry
and applications of nonsilver halide
photographic processes", 1965, Seiten 137-157,
Wiley, New York, US; Kapitel 4: "Unsaturated
compounds"**
**IBM TECHNICAL DISCLOSURE BULLETIN, Band
15, Nr. 1, Juni 1972, Seite 174, New York, US;
C.A. CORTELLINO et al.: "Solventless
development of polymeric films"**
**INDUSTRIE CHIMIQUE BELGE, Band 39, Nr. 3,
März 1974, Seiten 249-265, Fédération des
industries chimiques, Bruxelles, BE; G.A.
DELZENNE: "Photographic applications of
photopolymers: photophysical and
photochemical aspects"**

## Beschreibung

Die Erfindung betrifft ein Verfahren zur Herstellung eines Resistmusters aus einem hochauflösenden strahlungsempfindlichen Resistmaterial, bei dem das Resistmaterial in dünner Schicht auf ein Substrat aufgebracht, mit energiereicher Strahlung, insbesondere Elektronenstrahlen, in einem vorbestimmten Muster bestrahlt wird sowie anschließend die nicht-bestrahlten Bereiche der Resistschicht entfernt werden.

Elektronenstrahlresists sind bekannt. Sie sind, in Abhängigkeit vom eingesetzten Resistmaterial, positiv oder negativ arbeitend und können insbesondere bei der Herstellung von Halbleiter-Anordnungen, integrierten Schaltkreisen, Mikroschaltungen, elektronischen Bauelementen und dergleichen eingesetzt werden. Gegenüber den bekannten Photoresists weisen die Elektronenstrahlresists den Vorteil auf, daß mit ihnen eine erheblich bessere Auflösung erzielt werden kann. Während für hohe Auflösungen im allgemeinen Positiv-Resists bevorzugt werden, sind Negativ-Resists üblicherweise etwas empfindlicher.

Als Resistmaterialien für Elektronenstrahl-Resists wurden bereits eine Vielzahl von verschiedenen Polymeren, wie z.B. Polymethylmethacrylat, Polyisobutylen, Polymethylisopropylenylketon, epoxidiertes Polybutadien, Polydiallylorthophthalat, Polysilikone, Polycarbonate oder halogenierte Polyethylene, vorgeschlagen. Zum Stand der Technik sei beispielsweise verwiesen auf: Polymer Eng. and Sci., Band 14, Nr. 7, S. 516—517 (1974); Org. Coatings and Applied Polymer Sci. Proc., Band 48, S. 150—155 (1983); Journal of Applied Polymer Sci., Band 25, S. 1131—1136 (1980); sowie Amer. Chem. Soc., Div. Org. Coatings Plast. Chem., Band 35, Nr. 1, S. 108—117 (1975). Die genannten Resistmaterialien sind für die verschiedenen Anwendungen unterschiedlich gut geeignet. Das Auftragen der Resistmaterialien auf das weiterzuverarbeitende Substrat erfolgt dabei aus Lösung. Ebenso wird die Entwicklung des Resistmusters nach der bildmäßigen Bestrahlung des Resistmaterials im allgemeinen mit einem Entwicklerlösungsmittel durchgeführt. Der Einsatz von Lösungsmittel sowie dessen Wiederaufarbeitung stellen einen nicht unbeachtlichen Aufwand dar.

Es wurde auch schon vorgeschlagen, die Flüssig-Entwicklung der Resistschichten durch eine Trocken-Entwicklung zu ersetzen, indem die bildmäßig belichtete Resistschicht mit einem Plasmagas geätzt wird (vgl. DE—C—27 26 813 und EP—A—17032). Als Resistmaterialien werden dabei Photoresists eingesetzt, die neben einem polymeren Bindemittel polymerisierbare Monomere enthalten. Monomerhaltige Resistschichten bedürfen einer sehr sorgfältigen Handhabung, teilweise unter Einhaltung besonderer Sicherheitsvorschriften. Ferner sind für die Trocken-Entwicklung von Resistschichten mittels Plasma-Ätzung technisch aufwendige und kostspielige Apparaturen notwendig.

Aus der DE—A—1 152 534 ist ein Verfahren zum Vernetzen von Kohlenwasserstoffen bekannt, die mit ultraviolettem Licht mit Wellenlängen zwischen 200 und 300 mµ bestrahlt werden, wobei die Entfernung der nicht-bestrahlten Teile durch Auswachen mit Toluol, Xylol oder Hexan erfolgt.

Der Publikation von J. Kosar "Light sensitive systems" in J.P.C. 1965, Seiten 137—157, Wiley, New York, ist ebenfalls ein Hinweis auf die Vernetzung von Polyethylen oder paraffinwachs durch Bestrahlung mit ultraviolettem Licht zu entnehmen.

Der vorliegenden Erfindung liegt die Aufgabe zugrunde, ein Verfahren zur Herstellung eines Resistmusters aufzuzeigen, welches in einfacher Weise durchgeführt und mit dem gleichzeitig eine hohe Auflösung erzielt werden kann. Aufgabe der Erfindung ist es ferner, ein weiteres, vorteilhaftes Resistmaterial für Elektronenstrahlresists aufzuzeigen.

Diese Aufgabe wird durch das erfindungsgemäße Verfahren gelöst.

Gegenstand der Erfindung ist demzufolge ein Verfahren zur Herstellung eines Resistmusters aus einem hochauflösenden, strahlungsempfindlichen Paraffin-Resistmaterial, welches dadurch gekennzeichnet ist, daß das Paraffin-Resistmaterial durch Aufdampfen in dünner Schicht schichtförmig auf ein Substrat aufgebracht, in einem vorbestimmten Muster unter Vernetzung des Resistmaterials bestrahlt wird sowie anschließend die nicht-bestrahlten Bereiche der Resistschicht durch Abdampfen des unvernetzten Paraffins entfernt werden.

Gegenstand der Erfindung sind des weiteren spezielle Ausgestaltungsformen dieses Verfahrens gemäß der nachfolgenden detaillierten Beschreibung der Erfindung.

Bei den erfindungsgemäß als Resistmaterialien einzusetzenden Paraffinen handelt es sich um geradkettige oder verzweigte, gesättigte, aliphatische Kohlenwasserstoffe, die gegebenenfalls auch, beispielsweise durch Carboxylgruppen, Estergruppen, Hydroxylgruppen oder dergleichen, substituiert sein können. Vorzugsweise werden jedoch unsubstituierte Paraffin-Kohlenwasserstoffe eingesetzt. Die erfindungsgemäß einzusetzenden Paraffine sind im allgemeinen bei Raumtemperatur fest und haben vorzugsweise einen Schmelzpunkt im Bereich von 30 bis 150°C, insbesondere im Bereich von etwa 40 bis 120°C. Es können aber auch niedrigschmelzendere, bei Raumtemperatur üblicherweise flüssige Paraffine eingesetzt werden, beispielsweise solche mit einem Fließpunkt bis hinab zu etwa −30°C, insbesondere wenn unter Kühlung des Substrates bei Temperaturen unterhalb des Fließpunktes der Paraffine gearbeitet wird. Die bevorzugt eingesetzten Paraffine lassen sich bei erhöhten Temperaturen, gegebenenfalls unter Anlegen eines Vakuums, ohne nennenswerte Zersetzung und insbesondere ohne Rückstandsbildung verdampfen. Besonders vorteilhaft sind Paraffine mit mindestens 10 C-Atomen und insbesondere solche, die etwa 20 bis 70 C-Atome besitzen. Das Molekulargewicht dieser Paraffine liegt im Bereich von 130 bis 1000. Vorzugsweise werden erfindungsgemäß als Resistmaterialien wachsartige Paraffine verwendet. Die Paraffine können einzeln oder in Mischung miteinander eingesetzt werden. Bei Paraffinen mit höherer C-Atom-Zahl handelt es sich in aller Regel um Gemische von Paraffinen etwa gleicher Kettenlänge und gleichen Molekulargewichts. In dem erfindungsgemäßen Verfahren können aber auch Mischungen von Paraffinen unterschiedlicher Kettenlänge und unterschiedlichen Molekulargewichts eingesetzt werden.

Als Substrat, auf das das Resistmaterial aufgebracht und auf dem anschließend das Resistmuster erzeugt wird, kommen die für Elektronenstrahl-Resists üblichen und gebräuchlichen Unterlagen in Betracht. Hierzu gehöhren beispielsweise keramische, metallische oder metalloxidische Untergründe oder Substrate oder mit metallischen oder metalloxidischen Schichten beschichtete Substrate. Insbesondere sind als Substrate Halbleiter-Elemente oder die bekannten und gebräuchlichen Wafer zu erwähnen. Bei den Wafern handelt es sich im allgemeinen um Silicium-, GaAs- oder InSb-Scheiben, die oberflächlich mit einer Oxid- oder allgemeinen Isolierschicht versehen sein können.

Das Aufbringen der Paraffine als Resistmaterial in dünner Schicht auf das Substrat erfolgt vorteilhaft und in einfacher Weise durch Aufdampfen, insbesondere im Vakuum.

Die Dicke der als Resistmaterial auf das Substrat aufgebrachten Paraffin-Schicht richtet sich nach dem beabsichtigten Verwendungszweck des Resistmusters und kann in breiten Grenzen, beispielsweise von 0,01 bis 10 µm, schwanken. Vorzugsweise liegt die Dicke der Resistschicht im Bereich von etwa 0,01 bis 2 µm, wobei insbesondere im Bereich von 0,05 bis 1 µm sehr vorteilhafte Ergebnisse erzielt wurden.

Die auf das Substrat aufgebrachte Resistschicht aus dem Paraffin wird mit einer elektromagnetischen Strahlung, die eine Vernetzung des Paraffins in den bestrahlten Bereichen zu bewirken vermag, bestrahlt. Hierfür kommen insbesondere energiereiche Strahlen, wie z.B. Elektronenstrahlen, Gammastrahlung oder dergleichen, zur Anwendung. So können in dem erfindungsgemäßen Verfahren beispielsweise Elektronenstrahlen mit einer Beschleunigungsspannung von etwa 10 bis 40 KeV, aber auch solche mit einer Beschleunigungsspannung von 100 bis 300 oder mehr KeV verwendet werden.

Insbesondere liegt die Beschleunigungsspannung bei Verwendung von Elektronenstrahlen im Bereich von etwa 10 bis 1000 KeV. Die Strahlendosis liegt üblicherweise im Bereich von $10^{-5}$ bis $10^{-1}$ C/cm², vorzugsweise im Bereich von $10^{-4}$ bis $10^{-2}$ C/cm². Als Strahlungsquellen für Gamma-Strahlung kommen beispielsweise $^{60}$Co-Quellen in Betracht. Die Bestrahlung des auf das Substrat aufgebrachten Resistmaterials erfolgt dabei in an sich bekannter Weise bildmäßig. d.h. in einem vorbestimmten Muster entsprechend dem gewünschten Resistmuster. Die Dauer der Bestrahlung hängt unter anderem von der Dicke der Resistschicht und der Art der verwendeten Strahlung ab und liegt im allgemeinen im Bereich von einigen Sekunden bis einigen Minuten. Bei Verwendung von Elektronenstrahlen liegt die Bestrahlungsdauer im allgemeinen umso höher, je größer die Beschleunigungsspannung ist. Typischer Weise wurde in dem erfindungsgemäßen Verfahren mit Bestrahlungsdauern beispielsweise im Bereich von 0,1 bis 10 Minuten, vorzugsweise im Bereich von 0,5 bis 2 Minuten, gearbeitet.

Durch die Bestrahlung wird das Paraffin in den bestrahlten Bereichen vernetzt. Zur Entwicklung des Resistmusters werden anschließend die nicht-bestrahlten, nicht-vernetzen Bereiche der Paraffin-Resistschicht entfernt. Die Entwicklung des Resistmusters kann dabei nach den bekannten Naß- oder Trockenentwicklungsverfahren durchgeführt werden, d.h. durch Behandeln der bildmäßig bestrahlten Resistschicht mit einem geeigneten Lösungsmittel oder durch Plasma-Ätzen mittels eines Plasma-Gases. Ein besonderer Vorteil des erfindungsgemäßen Verfahrens liegt darin, daß die Entwicklung des Resistmusters nach der bildmäßigen Bestrahlung der Resistschicht in einfacher Weise durch Abdampfen der nichtbestrahlten Bereiche der Paraffinschicht vorgenommen werden kann. Das Abdampfen des Paraffins erfolgt beispielsweise im Vakuum bei erhöhten Temperaturen, beispielsweise im Bereich von etwa 50 bis 200°C, je nach Höhe des angelegten Vakuums, Art des Paraffins und vorgesehener Entwicklungszeit.

Das erfindungsgemäße Verfahren führt zu Resistmustern, die eine exakte und scharfe Wiedergabe der Vorlage mit sehr gut ausgebildeten Kantenstrukturen darstellen und die eine hohe Auflösung besitzen. So ist es mit dem erfindungsgemäßen Verfahren möglich. Abbildungen z.B. mit Liniendicken und -abständen in einem Bereich unterhalb der Schichtdicke der Resistschicht zu erzeugen. Beispielsweise konnten bei einem 0,1 µm dicken Resistfilm ohne weiteres Linienweiten von 0,04 µm exakt reproduziert werden. Das Auflösungsvermögen kann, u.a. in Abhängigkeit von der Fkoussierung des Strahls und der Dicke der Paraffin-Resistschicht, bis zu etwa 2 nm betragen. Das erfindungsgemäße Verfahren hat den weiteren Vorteil, daß es im Vergleich zu den bisher bekannten Verfahren in sehr einfacher Weise durchzuführen ist, da das Paraffin als Resistmaterial auf das Substrat aufgedampft bzw. nach der bildmäßigen Bestrahlung das nicht-vernetzte Paraffin auch wieder abgedampft werden kann. Dadurch wird es beispielsweise möglich, das Aufbringen des Resistmaterials auf das Substrat, die Bestrahlung der Resistschicht mit Elektronenstrahlen sowie das Abdampfen der nicht-bestrahlten, nicht-vernetzten Bereiche der Paraffin-Resistschicht unter Entwicklung des Resistmusters in direkt aufeinanderfolgenden Schritten in einer einfachen Vakuumkammer als Apparatur auszuführen. Dadurch wird die Verwendung von Lösungsmitteln zum Aufbringen oder zum Entwickeln der Resistschicht vermieden.

Nach dem Entfernen der nicht-bestrahlten Bereiche der Resistschicht unter Entwickeln des Resistmusters können die freigelegten Bereiche des Substrats in an sich bekannter und üblicher Weise, insbesondere durch Ätzen oder Dotieren, aber auch durch Metallabscheidung, dauerhaft modifiziert werden. Die nach dem erfindungsgemäßen Verfahren herstellten Resistmuster können, wie die bekannten Elektronenstrahlresists, bei der Herstellung von Leiterbahnen, gedruckten Schaltungen, Dünnschicht- oder Mikroschaltungen, integrierten Schaltkreisen, Halbleiteranordnungen, elektronischen Bauelementen und dergleichen eingesetzt werden. Durch die erzielbaren hohen Auflösungen lassen sich dabei auch feinste Bildelemente vorlagengetreu reproduzieren. Die erfindungsgemäß hergestellten Resistmuster zeichnen sich durch eine gute Beständigkeit in der Weiterverarbeitung aus. Nach der dauerhaften Modifizierung des Substrats lassen sie sich von der Unterlage nach den üblichen und bekannten Techniken entfernen.

Die Erfindung wird durch die nachfolgenden Beispiele näher erläutert.

### Beispiel

Auf ein Kohlesubstrat wurde im Vakuum (ca. $10^{-6}$ Torr) bei einer Temperatur von 170°C ein Paraffin mit einer Schmelztemperatur im Bereich von 69 bis 73°C aufgedampft. Das Paraffin besaß etwa 44 Kohlenstoffatome. Der Abstand der Bedampfungsquelle zum Substrat betrug 20 cm, die Bedampfungszeit etwa 30 sec. Dabei wurde auf dem Substrat ein etwa 0,3 µm dicker Paraffinfilm erzeugt. Dieser Paraffinfilm wurde anschließend in einem Raster-Transmissions-Elektronenmikroskop (Fa. JEOL; Typ: JEM 200 CX) mittels eines Elektronenstrahls in einem vorgegebenen Rastermuster bestrahlt. Die Beschleunigungsspannung betrug 200 KeV; die elektronenoptische Vergrößerung war 20.000-fach; der Strahlstrom an der Anode wurde zu 170 µA gemessen. Die Resistschicht wurde in 5 Scan-Durchgängen mit dem Rastermuster bestrahlt, wobei die gesamte Bestrahlungszeit 60 sec betrug. Anschließend wurde der bestrahlte Resist im Vakuum ($10^{-6}$ Torr) 30 Minuten lang auf 120°C erwärmt. Hierbei verdampfte das nicht durch den Elektronenstrahl vernetzte Paraffin. Es wurde ein originalgetreues Resistmuster mit scharf ausgeprägten Konturen und steilen Flanken erhalten. Die Auflösung betrug 0,002 µm.

### Patentansprüche

1. Verfahren zur Herstellung eines Resistmusters aus einem hochauflösenden strahlungsempfindlichen Paraffin-Resistmaterial, dadurch gekennzeichnet, daß das Paraffin-Resistmaterial durch Aufdampfen in dünner Schicht schichtförmig auf ein Substrat aufgebracht, in einem vorbestimmten Muster unter Vernetzung des Resistmaterials bestrahlt wird sowie anschließend die nicht-bestrahlten Bereiche der Resistschicht durch Abdampfen des unvernetzten Paraffins entfernt werden.

2. Verfahren nach Anspruch 1, dadurch gekennzeichnet, daß als Resistmaterial ein Paraffin mit einem Schmelzpunkt im Bereich von etwa $-30$ bis 150°C aufgebracht wird.

3. Verfahren nach einem der Ansprüche 1 oder 2, dadurch gekennzeichnet, daß als Resistmaterial ein Paraffin aufgebracht wird, das etwa 10 bis 70 C-Atome besitzt.

4. Verfahren nach einem der Ansprüche 1 bis 3, dadurch gekennzeichnet, daß als Resistmaterial ein wachsartiges Paraffin aufgebracht wird.

5. Verfahren nach einem der Ansprüche 1 bis 4, dadurch gekennzeichnet, daß als Reistmaterial ein Gemisch aus verschiedenen Paraffinen aufgebracht wird.

6. Verfahren nach einem der Ansprüche 1 bis 5, dadurch gekennzeichnet, daß die Bestrahlung der Resistschicht in dem vorbestimmten Muster mittels eines Elektronenstrahles erfolgt.

7. Verfahren nach Anspruch 6, dadurch gekennzeichnet, daß zur Bestrahlung des Resistmaterials ein Elektronenstrahl mit einer Beschleunigungsspannung von 10 bis 1000 KeV und einer Ladungsdichte von $10^{-5}$ bis $10^{-1}$ C/cm$^2$ angewandt wird.

### Revendications

1. Procédé de confection d'un modèle réserve (resist) à partir d'un matériau réserve en paraffine à pouvoir résolvant élevé, sensible ay rayonnement, caractérisé par le fait que le matériau réserve en paraffine est appliqué en couche mince, par vaporisation, sur un substrat, il est irradié en un dessin donné d'avance, avec réticulation du matériau réserve, et les zones non irradiées de la couche réserve sont ensuite éliminées par vaporisation de la paraffine non réticulée.

2. Procédé selon la revendication 1, caractérisé par le fait qu'on applique comme matériau réserve une paraffine d'un point de fusion compris entre environ $-30$ et 150 degrés C.

3. Procédé selon l'une des revendications 1 ou 2, caractérisé par le fait qu'on applique comme matériau réserve une paraffine présentant environ 10 à 70 atomes C.

4. Procédé selon l'une des revendications 1 à 3, caractérisé par le fait qu'on applique comme matériau réserve une paraffine du type des cires.

5. Procédé selon l'une des revendications 1 à 4, caractérisé par le fait qu'on applique comme matériau réserve un mélange de différentes paraffines.

6. Procédé selon l'une des revendications 1 à 5, caractérisé par le fait que l'irradiation de la couche réserve, en un dessin donné d'avance, est effectuée au moyen d'un rayon d'électrons.

7. Procédé selon la revendication 6, caractérisé par le fait que pour l'irradiation du matériau réserve on utilise un rayon d'électrons d'une tension accélératrice de 10 à 1000 KeV et d'une densité de charge de $10^{-5}$ à $10^{-1}$ C/cm².

## Claims

1. A process for the production of a resist image from a high-resolution, radiation-sensitive paraffin resist material, wherein the latter is applied as a layer onto a substrate in a thin layer by vapor deposition and is irradiated in a predetermined pattern with crosslinking of the resist material, and the non-irradiated parts of the resist layer are then removed by evaporating the non-crosslinked paraffin.

2. A process as claimed in claim 1, wherein the resist material applied is a paraffin having a melting point of from about −30 to 150°C.

3. A process as claimed in either of claims 1 or 2, wherein the resist material applied is a paraffin which possesses about 10 to 70 carbon atoms.

4. A process as claimed in any of claims 1 to 3, wherein the resist material applied is a wax-like paraffin.

5. A process as claimed in any of claims 1 to 4, wherein the resist material applied is a mixture of different paraffins.

6. A process as claimed in any of claims 1 to 5, wherein the resist layer is irradiated in a predetermined pattern by means of an electron beam.

7. A process as claimed in claim 6, wherein, for irradiation of the resist material, an electron beam having an acceleration voltage of from 10 to 1,000 KeV and a charge density of from $10^{-5}$ to $10^{-1}$ C/cm² is used.